# EUROPEAN PATENT SPECIFICATION

(11) **EP 3 339 854 B1**
(45) Date of publication and mention of the grant of the patent: **03.02.2021**
(21) Application number: 17206856.1
(22) Date of filing: 12.12.2017
(51) Int. Cl.: G01N 29/22, G01H 11/08, G01N 29/34, B06B 1/06, G01N 29/36, H01L 41/053, H01L 41/113, H01L 41/23, H01L 41/313

(54) **EXPLOSION PROOF PIEZOELECTRIC ULTRASONIC DETECTOR**
EXPLOSIONSGESCHÜTZTER PIEZOELEKTRISCHER ULTRASCHALLDETEKTOR
DÉTECTEUR À ULTRASONS PIÉZOÉLECTRIQUE ANTIDÉFLAGRANT

(30) Priority: 21.12.2016 US 201662437382 P
(43) Date of publication of application: 27.06.2018
(60) Divisional application: 20203343.7
(73) Proprietor: Honeywell International Inc., Morris Plains, NJ 07950 (US)
(72) Inventor: GRANT, Michael, Morris Plains, NJ 07950 (US); CUTLER, Jeffrey, Morris Plains, NJ 07950 (US); WATTS, Rodney Royston, Morris Plains, NJ 07950 (US)
(74) Representative: Haseltine Lake Kempner LLP

(56) References cited:
- WO-A1-2016/126533
- JP-A- H11 266 498
- US-A1- 2015 377 693

## Description

### BACKGROUND

Explosion proof devices may be used in hazardous environments such as a gas pipeline, a hydrocarbon well site, a gas pipeline compression station, a chemical refinery and other environments that may be subject to explosions. For example, leakage of a pressurized gas may unintentionally occur when bad pipe joints leak or pipes are damaged, for example due to hitting the pipe accidently with metal equipment. An ignition of a leaking gas may be triggered by a spark or other event. Depending on circumstances, the ignition of a leaking gas may be accompanied by an initial explosion which produces very high transient pressures.

Patent document number JP-H11-266498A describes an ultrasonic wave sensor which consists of a cylindrical case, a piezoelectric vibrator disposed in the bottom of the cylindrical case. Input and output terminals connect electrically to the piezoelectric vibrator and lead out to the outside of the cylindrical case. A buffer member suppresses a reverberation wave and a foamed resin packed in the inside of the bottomed cylindrical case is used to buffer the material..

Patent document number WO2016/126533A1 describes an ultrasonic detector comprising a piezoelectric element operable to convert the pressure of sound waves from mechanical energy into electric signal; a protective cover; a hot melt adhesive; one or more layers of solder; one or more perforated metal electrodes comprising openings filled with the solder; and one or more support elements. The ultrasonic detector also comprises one or more casing elements operable to enclose and house the other elements of the ultrasonic detector; a printed circuit board (PCB) operable to receive ultrasonic data from the piezoelectric element and electrodes. The electrodes connect to, or contact, the PCB. An insulator is located in proximity to the electrodes and operable to prevent shorting between the metal electrodes and the metal casing elements.

### SUMMARY

The present invention in its various aspects is as set out in the appended claims.

An explosion proof ultrasonic detector is disclosed in claim 1.

A method for assembling an explosion proof ultrasonic detector is disclosed in claim 11.

For a more complete understanding of the present disclosure, reference is now made to the following brief description, taken in connection with the accompanying drawings and detailed description, wherein like reference numerals represent like parts.
FIG. 1 is an illustration of an explosion proof ultrasonic detector according to an embodiment of the disclosure.
FIG. 2 is an exploded view of some parts of an explosion proof ultrasonic detector according to an embodiment of the disclosure.
FIG. 3 is an illustration of another explosion proof ultrasonic detector according to an embodiment of the disclosure.
FIG. 4 is an illustration of yet another explosion proof ultrasonic detector according to an embodiment of the disclosure.

### DETAILED DESCRIPTION

It should be understood at the outset that although illustrative implementations of one or more embodiments are illustrated below, the disclosed systems and methods may be implemented using any number of techniques, whether currently known or not yet in existence. The disclosure should in no way be limited to the illustrative implementations, drawings, and techniques illustrated below, but may be modified within the scope of the appended claims.

The following brief definition of terms shall apply throughout the application:
The term "comprising" means including but not limited to, and should be interpreted in the manner it is typically used in the patent context;
The phrases "in one embodiment," "according to one embodiment," and the like generally mean that the particular feature, structure, or characteristic following the phrase may be included in at least one embodiment of the present invention, and may be included in more than one embodiment of the present invention (importantly, such phrases do not necessarily refer to the same embodiment);
If the specification describes something as "exemplary" or an "example," it should be understood that refers to a non-exclusive example;
The terms "about" or "approximately" or the like, when used with a number, may mean that specific number, or alternatively, a range in proximity to the specific number, as understood by persons of skill in the art field; and
If the specification states a component or feature "may," "can," "could," "should," "would," "preferably," "possibly," "typically," "optionally," "for example," "often," or "might" (or other such language) be included or have a characteristic, that particular component or feature is not required to be included or to have the characteristic. Such component or feature may be optionally included in some embodiments, or it may be excluded.

Embodiments of the disclosure include methods and systems for providing an explosion proof piezoelectric sensor. Unintentional leakage of gas from pressurized installations, which may be caused by failed pipe joints, or a pipe fracture, needs to be detected as quickly as possible, as the leaking gas might be dangerous for the environment or may lead to severe product losses. Once a leak is detected, it may be indicated to a monitor or supervisor, so the leak may be contained or otherwise mitigated. Due to the nature of gas leaks, detection instruments may be required to be explosion proof, so that detection may continue even if an explosion occurs near the instrument, and/or so that an explosion initiated within the instrument does not propagate to an external environment.

A gas leakage from a pressurized source may produce sound, which typically has frequencies in the audible and ultrasonic ranges. An ultrasonic detector may be configured to detect ultrasound frequencies generated by a gas leak, and therefore, detect the gas leak. The ultrasonic detector may signal the level of the detected ultrasound, and may be configured to activate an alarm if the detected ultrasound level is above a certain threshold.

Embodiments of the disclosure relate to explosion proof ultrasonic detectors, which may comprise one or more piezoelectric element encapsulated in a metal enclosure, where the piezoelectric element may convert the pressure of sound waves from mechanical energy into an electric signal.

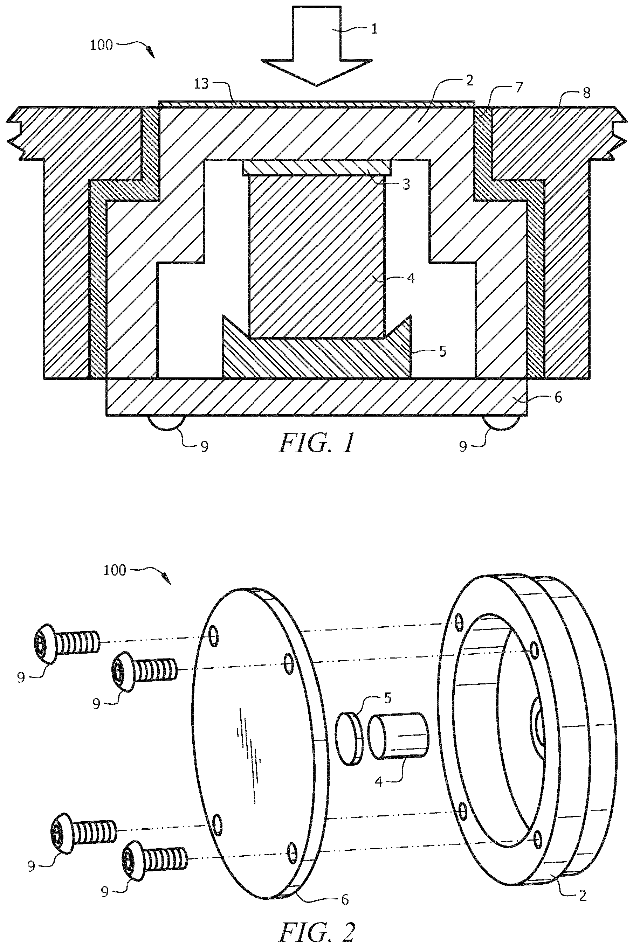

FIG. 1 illustrates an explosion proof ultrasonic detector 100, where arrow 1 illustrates ultrasound pressure waves coming from the environment. The explosion proof ultrasonic detector 100 may comprise a metal enclosure 2 facing the ultrasound pressure waves, where the metal enclosure 2 may function as one of the electrodes of a sense element 4 (which may be a piezoelectric sense element, or may also be known as a piezo sense element). The sense element 4 is attached to the metal enclosure 2 via solder 3. The sense element 4 may also comprise one or more electrodes, which may be silver electrodes. Additionally, the sense element 4 is in contact with an electrically conductive compression element 5 and a printed circuit board (PCB) 6. The PCB 6 is configured to compress the electrically conductive compression element 5 and to connect electrically to an electrode of the sense element 4. The explosion proof ultrasonic detector 100 may also comprise an instrument enclosure 8 that may be sealed to the metal enclosure 2 via a layer of sealing material 7.

As shown in FIG. 1, the sense element 4 is soldered directly to the metal enclosure 2, and the metal enclosure 2 may be directly attached to the PCB 6 via screws 9. The metal enclosure 2 may function as an electrode by directly contacting the PCB 6 and connecting the sense element 4 to the PCB 6. The electrically conductive compression element 5 provides explosion protection to the sense element 4, and possibly the other elements of the explosion proof ultrasonic detector 100. The electrically conductive compression element 5 may further provide adaptation of fit of parts in the context of dimensional variation within tolerance limits of manufactured parts. When the explosion proof ultrasonic detector 100 is assembled, the sense element 4 is under compression between the metal enclosure 2 (and solder 3) and the PCB 6, via the electrically conductive compression element 5. This compression may reduce the risk of separation between the sense element 4 and the electrodes and/or PCB 6, which could occur due to strong mechanical shock, vibration, thermal shock, and/or excessive piezo resonance. Use of the electrically conductive compression element 5 between the sense element 4 and the PCB 6 allows the compression of the sense element 4 to be maintained over a large temperature range without damaging the explosion proof ultrasonic detector 100 assembly, where the elasticity of the electrically conductive compression element 5 may be configured to distribute compressive force evenly. The solder 3 may be resistant to very wide temperature ranges and thermal cycling, and may be able to withstand shock and impact without the solder 3 joint failing. The solder 3 may also provide a reliable electrical contact between the sense element 4 and the PCB 6 via the metal enclosure 2.

The surface of the metal enclosure 2 attached to the sense element 4 may function as a membrane to transfer ultrasound pressure waves 1 from the external environment to the sense element 4 while also protecting the sense element 4 from the force of an explosive blast. The sealing material 7 may provide a water-tight seal with the metal enclosure 2, protecting the sense element 4, the electrically conductive compression element 5, and the PCB 6. The sealing material 7 may provide electrical isolation between the metal enclosure 2 and the instrument enclosure 8. The sealing material 7 may also provide isolation (i.e., sound insulation) to prevent the propagation of ultrasonic signals from the instrument enclosure 8 into the sense element 4 and/or the metal enclosure 2. Ultrasonic signals may originate in the instrument enclosure 8 as a consequence of impact or vibration. In an embodiment, the sealing material 7 may comprise silicone. In an embodiment, the sealing material 7 may be provided as a pre-molded part, for example a pre-molded silicone part. In an embodiment, the sealing material 7 may have a length or height of about 15.9 mm. In an embodiment, the sealing material 7 may have a length or height that is sufficient to resist explosions up to a predefined maximum strength.

The sense element 4 may operate in a Faraday cage, being surrounded by metal surfaces via the metal enclosure 2 and PCB 6. Said in another way, the metal enclosure 2 and the PCB 6 may form a Faraday cage that encloses the sense element 4. In an embodiment, the Faraday cage formed by the metal enclosure 2 and the PCB 6 may further enclose some electronic devices installed on the PCB 6. The PCB 6 may comprise a continuous metal layer which may contact the metal enclosure 2 of the explosion proof ultrasonic detector 100. This configuration may minimize the influence of electromagnetic interference (EMI), provide electromagnetic compatibility, and may allow the explosion proof ultrasonic detector 100 to achieve high signal to noise ratio (SNR) performance.

A front face of the metal enclosure 2, which faces incoming ultrasound pressure waves 1, may comprise a coating 13, which may comprise a polymer such as Polytetrafluoroethylene (PTFE), another similar material, or a plastic label. The coating 13 may function as a protective cover for the metal enclosure 2 resistant to many aggressive chemicals, may function in a broad temperature range, and may not compromise the acoustic properties of the metal enclosure 2, allowing ultrasound waves to pass through. In an embodiment, the coating 13 may improve the acoustic transfer of energy from the ultrasound pressure waves 1 to the metal enclosure 2 and/or to the sense element 4.

The explosion proof ultrasonic detector 100 described in FIG. 1 may comprise very few components which promote simple assembly optimized for manufacturing. Typical ultrasound detection products may not comprise explosion proof elements. An explosion proof, highly reliable, ultrasonic sense element (which may comprise a microphone) may be preferred for detecting gas leaks through airborne ultrasound pressure waves, especially in an environment where harmful substances, such as H₂S, may be present.

FIG. 2 illustrates an exploded view of the explosion proof ultrasonic detector 100, comprising the metal enclosure 2, one or more piezoelectric sense element 4, electrically conductive compression element 5, PCB 6, and screws 9 for assembly. In an embodiment, the electrically conductive compression element 5 may comprise rubber material. Note that FIG. 2 does not depict the presence of solder 3 which may not be provided until final assembly or manufacturing of the explosion proof ultrasonic detector 100. Said in other words, the solder 3 may be considered to be separate from a part of the kit for assembling and manufacturing the explosion proof ultrasonic detector 100 and may be provided during the manufacturing process as a consumable tool or consumable material.

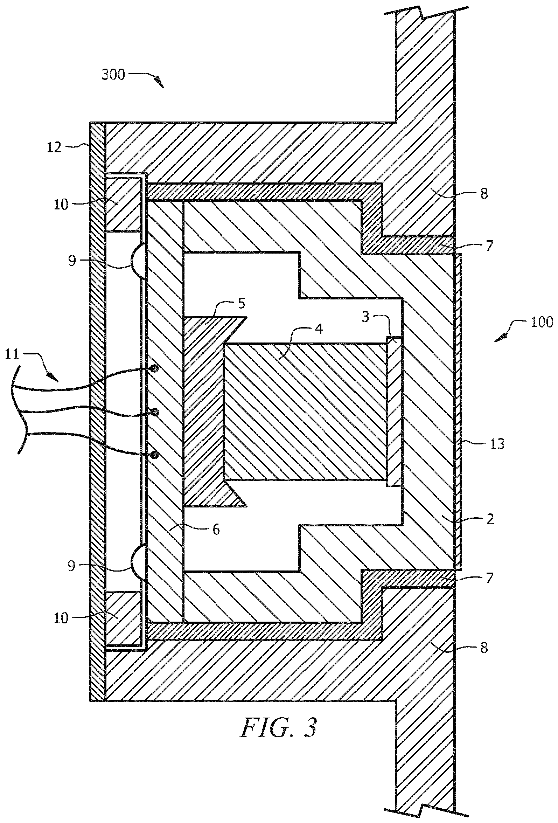

FIG. 3 illustrates an explosion proof ultrasonic detector 100 attached to an exemplary instrument 300. As an example, the exemplary instrument 300 may be required to survive at least 600 psi (4.137 MPa) pressure from outside toward the instrument and/or from the interior of the instrument toward environment. Alternatively, the exemplary instrument 300 and the explosion proof ultrasonic detector 100 may be required to survive other predefined pressures. The explosion proof ultrasonic detector 100 installed in the instrument 300 may be secured from the interior of the instrument 300 with a locking ring 10, or another similar mechanical element. In some embodiments, the explosion proof ultrasonic detector 100 may be separated from the interior of the instrument 300, such as via a layer of sealant 12. The sealant 12 may comprise silicone. One or more leads 11 from the PCB 6 may extend into the interior of the instrument 300 through the locking ring 10 and/or sealant 12.

Soldering of the sense element 4 to the metal enclosure 2 may be completed with a solder 3 having a low melting temperature that is lower than the Curie temperature of the material of the sense element 4, thereby preventing any sensitivity loss for the sense element 4. As an example, the Curie temperature of the sense element 4 may be approximately 300°C. The coating 13 (which may comprise PTFE) on the metal enclosure 2 may prevent bimetallic corrosion between the metal enclosure 2 of the ultrasonic sensor and the instrument enclosure 8, as these may be made from different metals.

Embodiments of the disclosure may include a method of assembling an explosion proof ultrasonic detector 100. The sense element 4 is soldered directly to the metal enclosure 2. Compression is applied to the sense element 4 via the electrically conductive compression element 5, wherein a consistent pressure is applied to the solder 3 material, improving the reliability of that connection. The PCB 6 may then be attached to the metal enclosure 2 via screws 9, wherein the PCB 6 contacts and maintains the compression from the electrically conductive compression element 5.

The metal enclosure 2 may be sealed to the instrument enclosure 8 via sealing material 7. Additionally, the coating 13 may be applied to the front face of the metal enclosure 2, wherein the coating 13 may reduce corrosion from exposure to harmful chemicals, and may improve ultrasound transmission through the metal enclosure 2.

In some embodiments, a locking ring 10 may be attached to the metal enclosure to further retain the metal enclosure within the instrument enclosure. In some embodiments, a layer of sealant 12 may be applied over the metal enclosure 2 to separate the metal enclosure and the other elements from the interior of the instrument enclosure 8.

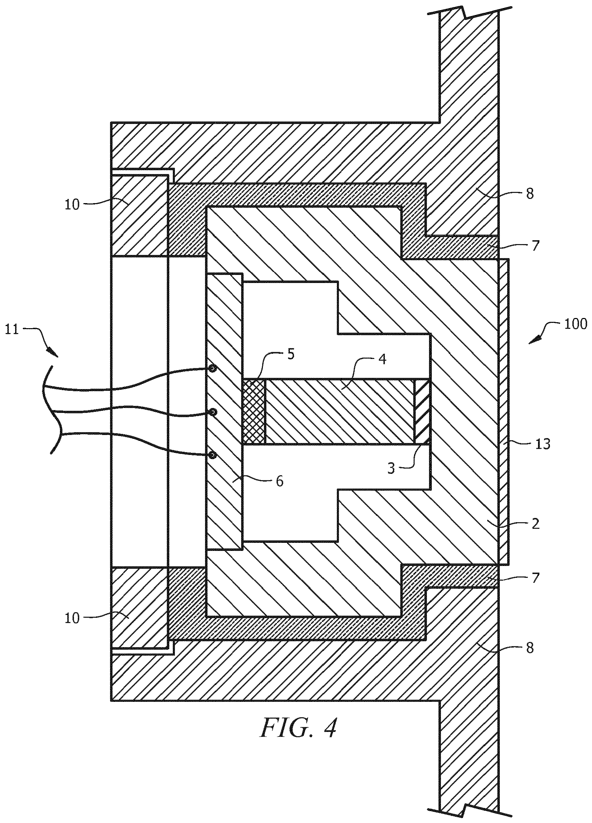

FIG. 4 illustrates an explosion proof ultrasonic detector 100 attached to an exemplary instrument 300. The explosion proof ultrasonic detector 100 attached to the exemplary instrument 300 is in all respects similar to the embodiments described above with reference to FIG. 1 and FIG. 3, with the exception that in the embodiment illustrated in FIG. 4 the instrument enclosure 8 has been extended so there is an offset between a leftwards facing surface of the metal enclosure 2 and a rightwards facing surface of the locking ring 10, the sealing material 7 has been extended to contact the edge of the locking ring 10, and the sealing material 7 extends between the metal enclosure 2 and the locking ring 10 (i.e., between a leftwards facing surface of the metal enclosure 2 and a rightwards facing surface of the locking ring 10). The extension of the sealing material 7 between the metal enclosure 2 and the locking ring 10 may provide additional electrical insulation and/or isolation of the explosion proof ultrasonic detector 100 from the instrument enclosure 8, additional mechanical buffering of the explosion proof ultrasonic detector 100 in the event of explosion, and additional sound insulation and/or isolation of the explosion proof ultrasonic detector 100 from the instrument enclosure 8. In an embodiment, the sealing material 7 may have a length or height of about 15.9 mm. In an embodiment, the sealing material 7 may have a length or height that is sufficient to resist explosions up to a predefined maximum strength.

Use of broader terms such as "comprises," "includes," and "having" should be understood to provide support for narrower terms such as "consisting of," "consisting essentially of," and "comprised substantially of." Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. An explosion proof ultrasonic detector (100) (100), comprising:
a metal enclosure (2) configured to face ultrasound pressure waves;
a sense element (4), wherein the sense element (4) is attached to the metal enclosure (2) via solder (3);
a compression element (5), wherein the compression element (5) is electrically conductive; and
a printed circuit board (PCB) (6),
wherein the metal enclosure (2) is directly attached to the PCB (6), which contacts the compression element (5), thereby compressing the sense element (4) via the compression element (5) to connect electrically to the sense element (4) and to provide explosion protection.

2. The explosion proof ultrasonic detector (100) of claim 1, wherein the sense element (4) comprises one or more electrodes, the metal enclosure (2) functions as an electrode of the sense element (4), and the metal enclosure (2) is directly attached to the PCB (6) via screws (9), thereby connecting the sense element (4) to an electronic circuit of the printed circuit board.

3. The explosion proof ultrasonic detector (100) of claim 1, wherein the sense element (4) comprises a piezoelectric sense element.

4. The explosion proof ultrasonic detector (100) of claim 1, wherein, when the detector is assembled, the sense element (4) is under compression between the metal enclosure (2) and solder (3) and the PCB (6), via the compression element (5).

5. The explosion proof ultrasonic detector (100) of claim 1, further comprising an instrument enclosure (8) sealed to the metal enclosure (2) and sealing material (7) between the metal enclosure (2) and the instrument enclosure (8), wherein the sealing material (7) provides isolation between the instrument enclosure (8) and the metal enclosure (2), thereby protecting the sense element (4), the compression element (5), and the PCB (6).

6. The explosion proof ultrasonic detector (100) of claim 5, further comprising a locking ring (10) configured to hold the metal enclosure (2) within the interior of the instrument enclosure (8).

7. The explosion proof ultrasonic detector (100) of claim 1, wherein the PCB (6) comprises a continuous metal layer contacting the metal enclosure (2).

8. The explosion proof ultrasonic detector (100) of claim 1, further comprising a coating (13) located on the outward facing surface of the metal enclosure (2), wherein the coating (13) is configured to allow ultrasound waves to pass through to the metal enclosure (2).

9. The explosion proof ultrasonic detector (100) of claim 1, wherein the detector is configured to survive at least 600 psi (4.137 MPa) pressure from the outside toward the detector and/or from the interior of the ultrasonic detector (100) outwards.

10. The explosion proof ultrasonic detector (100) of claim 1, wherein the solder (3) has a melting temperature lower than a Curie temperature of the material of the sense element (4).

11. A method for assembling an explosion proof ultrasonic detector (100), the method comprising:
soldering a first surface of a sense element (4) to an inner surface of a metal enclosure (2);
applying compression to a second surface of the sense element (4), wherein the second surface is opposite the first surface;
maintaining the compression to the second surface of the sense element (4) via an electrically conductive compression element (5); and
attaching a printed circuit board (PCB) (6) directly to the metal enclosure (2), wherein the PCB (6) contacts the compression element (5) thereby compressing the sense element (4) via the compression element (5) to connect electrically to the sense element (4) and to provide explosion protection.

12. The method of claim 11, further comprising applying a coating (13) to at least a portion of the outer surface of the metal enclosure (2).

13. The method of claim 11, further comprising sealing at least a portion of an outer surface of the metal enclosure (2) to an instrument enclosure (8).

14. The method of claim 13, further comprising attaching a locking ring (10) to the PCB (6) and/or metal enclosure (2) configured to retain the metal enclosure (2) within the instrument enclosure (8).

15. The method of claim 11, wherein soldering heats the sense element (4) to a temperature lower than a Curie temperature of the material of the sense element (4).

## Patentansprüche

1. Explosionsgeschützter Ultraschalldetektor (100) (100), umfassend:
ein Metallgehäuse (2), das konfiguriert ist, um Ultraschalldruckwellen ausgesetzt zu sein;
einen Messfühler (4), wobei der Messfühler (4) mittels Lot (3) an dem Metallgehäuse (2) befestigt ist;
ein Kompressionselement (5), wobei das Kompressionselement (5) elektrisch leitend ist; und
eine Leiterplatte (PCB) (6),
wobei das Metallgehäuse (2) direkt an der PCB (6), die das Kompressionselement (5) berührt, befestigt ist, wodurch der Messfühler (4) mittels des Kompressionselements (5) komprimiert wird, um elektrisch mit dem Messfühler (4) zu verbinden, und um Explosionsschutz bereitzustellen.

2. Explosionsgeschützter Ultraschalldetektor (100) nach Anspruch 1, wobei das Messfühler (4) eine oder mehrere Elektroden umfasst, das Metallgehäuse (2) als eine Elektrode des Messfühlers (4) fungiert, und das Metallgehäuse (2) mittels Schrauben (9) direkt an der PCB (6) angebracht ist, wodurch der Messfühler (4) mit einer elektronischen Schaltung der Leiterplatte verbunden ist.

3. Explosionsgeschützter Ultraschalldetektor (100) nach Anspruch 1, wobei das Messfühler (4) ein piezoelektrischer Messfühler umfasst.

4. Explosionsgeschützter Ultraschalldetektor (100) nach Anspruch 1, wobei, wenn der Detektor zusammengebaut wird, der Messfühler (4) zwischen dem Metallgehäuse (2) und dem Lot (3) sowie der PCB (6) über das Kompressionselement (5) unter Kompression steht.

5. Explosionsgeschützter Ultraschalldetektor (100) nach Anspruch 1, der ferner ein Instrumentengehäuse (8) umfasst, das an dem Metallgehäuse (2) und Dichtungsmaterial (7) zwischen dem Metallgehäuse (2) und dem Instrumentengehäuse (8) abgedichtet ist, wobei das Dichtungsmaterial (7) eine Isolierung zwischen dem Instrumentengehäuse (8) und dem Metallgehäuse (2) bereitstellt, wodurch der Messfühler (4), das Kompressionselement (5) und die PCB (6) geschützt sind.

6. Explosionsgeschützter Ultraschalldetektor (100) nach Anspruch 5, der ferner einen Verriegelungsring (10), der konfiguriert ist, um das Metallgehäuse (2) innerhalb des Inneren des Instrumentengehäuses (8) zu halten, umfasst.

7. Explosionsgeschützter Ultraschalldetektor (100) nach Anspruch 1, wobei die PCB (6) eine durchgehende Metallschicht, die das Metallgehäuse (2) berührt, umfasst.

8. Explosionsgeschützter Ultraschalldetektor (100) nach Anspruch 1, der ferner eine Beschichtung (13), die sich auf Oberfläche des Metallgehäuses (2), die nach außen gewandt ist, befindet, wobei die Beschichtung (13) konfiguriert ist, um es Ultraschallwellen zu erlauben, zu dem Metallgehäuse (2) durchzugehen.

9. Explosionsgeschützter Ultraschalldetektor (100) nach Anspruch 1, wobei der Detektor konfiguriert ist, um einem Druck von mindestens 600 psi (4,137 MPa) von außerhalb zu dem Detektor und/oder von dem Inneren des Ultraschalldetektors (100) nach außen standzuhalten.

10. Explosionsgeschützter Ultraschalldetektor (100) nach Anspruch 1, wobei das Lot (3) eine Schmelztemperatur aufweist, die niedriger als eine Curie-Temperatur des Materials des Messfühlers (4) ist.

11. Verfahren zum Zusammenbauen eines explosionsgeschützten Ultraschalldetektors (100), wobei das Verfahren umfasst:
Löten einer ersten Oberfläche eines Messfühlers (4) an eine Innenoberfläche eines Metallgehäuses (2);
Anlegen einer Kompression an eine zweite Oberfläche des Messfühlers (4), wobei die zweite Oberfläche der ersten Oberfläche entgegengesetzt ist;
Aufrechterhalten der Kompression an der zweiten Oberfläche des Messfühlers (4) über ein elektrisch leitendes Kompressionselement (5); und
Anbringen einer Leiterplatte (PCB) (6) direkt an dem Metallgehäuse (2), wobei die PCB (6) das Kompressionselement (5) berührt, wodurch der Messfühler (4) über des Kompressionselements (5) komprimiert wird, um elektrisch mit dem Sensorelement (4) zu verbinden.

12. Verfahren nach Anspruch 11, das ferner das Aufbringen einer Beschichtung (13) auf mindestens einen Abschnitt der Außenoberfläche des Metallgehäuses (2) umfasst.

13. Verfahren nach Anspruch 11, das ferner das Abdichten mindestens eines Abschnitts einer Außenoberfläche des Metallgehäuses (2) an einem Instrumentengehäuse (8) umfasst.

14. Verfahren nach Anspruch 13, das ferner das Anbringen eines Verriegelungsrings (10), der konfiguriert ist, um das Metallgehäuse (2) innerhalb des Instrumentengehäuses (8) zu halten, an der PCB (6) und/oder dem Metallgehäuse (2) umfasst.

15. Verfahren nach Anspruch 11, wobei das Löten den Messfühler (4) auf eine Temperatur erhitzt, die niedriger als eine Curie-Temperatur des Materials des Messfühlers (4) ist.

## Revendications

1. Détecteur à ultrasons antidéflagrant (100) (100), comprenant :
une enceinte métallique (2), conçue pour faire face aux ondes de pression ultrasonores ;
un élément de détection (4), l'élément de détection (4) étant fixé à l'enceinte métallique (2) par l'intermédiaire d'une soudure (3) ;
un élément de compression (5), l'élément de compression (5) étant électroconducteur ; et
une carte de circuit imprimé (PCB) (6),
dans lequel l'enceinte métallique (2) est directement fixée à la PCB (6), qui entre en contact avec l'élément de compression (5), ce qui comprime l'élément de détection (4) par l'intermédiaire de l'élément de compression (5) pour se connecter électriquement à l'élément de détection (4) et pour fournir une protection contre les explosions.

2. Détecteur à ultrasons antidéflagrant (100) selon la revendication 1, dans lequel l'élément de détection (4) comprend une ou plusieurs électrodes, dans lequel l'enceinte métallique (2) fonctionne comme une électrode de l'élément de détection (4) et dans lequel l'enceinte métallique (2) est directement fixée à la PCB (6) par l'intermédiaire de vis (9), ce qui connecte l'élément de détection (4) à un circuit électronique de la carte de circuit imprimé.

3. Détecteur à ultrasons antidéflagrant (100) selon la revendication 1, dans lequel l'élément de détection (4) comprend un élément de détection piézoélectrique.

4. Détecteur à ultrasons antidéflagrant (100) selon la revendication 1, dans lequel, lorsque le détecteur est assemblé, l'élément de détection (4) est en compression entre l'enceinte métallique (2), la soudure (3) et la PCB (6), par l'intermédiaire de l'élément de compression (5).

5. Détecteur à ultrasons antidéflagrant (100) selon la revendication 1, comprenant en outre une enceinte d'instrument (8) scellée à l'enceinte métallique (2) et un matériau d'étanchéité (7) entre l'enceinte métallique (2) et l'enceinte d'instrument (8), le matériau d'étanchéité (7) assurant l'isolation entre l'enceinte d'instrument (8) et l'enceinte métallique (2), ce qui protège l'élément de détection (4), l'élément de compression (5) et la PCB (6).

6. Détecteur à ultrasons antidéflagrant (100) selon la revendication 5, comprenant en outre une bague de verrouillage (10) conçue pour maintenir l'enceinte métallique (2) à l'intérieur de l'enceinte d'instrument (8).

7. Détecteur à ultrasons antidéflagrant (100) selon la revendication 1, dans lequel la PCB (6) comprend une couche métallique continue en contact avec l'enceinte métallique (2).

8. Détecteur à ultrasons antidéflagrant (100) selon la revendication 1, comprenant en outre un revêtement (13) situé sur la surface tournée vers l'extérieur de l'enceinte métallique (2), le revêtement (13) étant conçu pour permettre aux ondes ultrasonores de traverser l'enceinte métallique (2).

9. Détecteur à ultrasons antidéflagrant (100) selon la revendication 1, dans lequel le détecteur est conçu pour supporter une pression d'au moins 600 psi (4,137 MPa) de l'extérieur vers le détecteur et/ou de l'intérieur du détecteur à ultrasons (100) vers l'extérieur.

10. Détecteur à ultrasons antidéflagrant (100) selon la revendication 1, dans lequel la soudure (3) a une température de fusion inférieure à une température de Curie du matériau de l'élément de détection (4).

11. Procédé d'assemblage d'un détecteur à ultrasons antidéflagrant (100), le procédé comprenant :
le soudage d'une première surface d'un élément de détection (4) à une surface intérieure d'une enceinte métallique (2) ;
l'application d'une compression à une seconde surface de l'élément de détection (4), la seconde surface étant opposée à la première surface ;
le maintien de la compression sur la seconde surface de l'élément de détection (4) par l'intermédiaire d'un élément de compression électroconducteur (5) ; et
la fixation d'une carte de circuit imprimé (PCB) (6) directement à l'enceinte métallique (2), la PCB (6) entrant en contact avec l'élément de compression (5), ce qui comprime l'élément de détection (4) par l'intermédiaire de l'élément de compression (5) pour se connecter électriquement à l'élément de détection (4) et pour assurer une protection contre les explosions.

12. Procédé selon la revendication 11, comprenant en outre l'application d'un revêtement (13) sur au moins une partie de la surface extérieure de l'enceinte métallique (2).

13. Procédé selon la revendication 11, comprenant en outre le scellement d'au moins une partie d'une surface extérieure de l'enceinte métallique (2) à une enceinte d'instrument (8).

14. Procédé selon la revendication 13, comprenant en outre la fixation d'une bague de verrouillage (10) à la PCB (6) et/ou à l'enceinte métallique (2), conçue pour retenir l'enceinte métallique (2) à l'intérieur de l'enceinte d'instrument (8).

15. Procédé selon la revendication 11, dans lequel la soudure chauffe l'élément de détection (4) à une température inférieure à une température de Curie du matériau de l'élément de détection (4).
